(19) Europäisches Patentamt / European Patent Office / Office européen des brevets

(11) **EP 3 008 476 B1**

(12) **EUROPEAN PATENT SPECIFICATION**

(45) Date of publication and mention
of the grant of the patent:
**02.05.2018 Bulletin 2018/18**

(21) Application number: **14728988.8**

(22) Date of filing: **10.06.2014**

(51) Int Cl.:
*G01R 19/00* (2006.01)          *H02M 3/135* (2006.01)
*H02M 1/44* (2007.01)          *H02M 1/08* (2006.01)

(86) International application number:
**PCT/EP2014/061988**

(87) International publication number:
**WO 2014/198702 (18.12.2014 Gazette 2014/51)**

(54) **POWER CONVERTER WITH CURRENT SENSING**

LEISTUNGSWANDLER MIT STROMMESSUNG

CONVERTISSEUR DE PUISSANCE À DÉTECTION DE COURANT

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **13.06.2013 US 201361834596 P**

(43) Date of publication of application:
**20.04.2016 Bulletin 2016/16**

(73) Proprietor: **IDT Europe GmbH
01109 Dresden (DE)**

(72) Inventor: **KELLY, Anthony
Old Kildimo
Co. Limerick (IE)**

(74) Representative: **Lippert Stachow Patentanwälte
Rechtsanwälte
Partnerschaft mbB
Krenkelstrasse 3
01309 Dresden (DE)**

(56) References cited:
**US-A1- 2006 158 363          US-A1- 2008 089 101
US-A1- 2008 284 352          US-A1- 2011 025 284**

• **SOUVIK CHATTOPADHYAY ET AL: "A Digital
Current-Mode Control Technique for DC-DC
Converters", IEEE TRANSACTIONS ON POWER
ELECTRONICS, INSTITUTE OF ELECTRICAL
AND ELECTRONICS ENGINEERS, USA, vol. 21,
no. 6, 1 November 2006 (2006-11-01), pages
1718-1726, XP011142827, ISSN: 0885-8993, DOI:
10.1109/TPEL.2006.882929**

## Description

FIELD OF THE INVENTION

The present disclosure relates to a power converter with current sensing and related method for controlling the power converter.

BACKGROUND OF THE INVENTION

In DC-DC conversion current sense techniques are an important aspect of the functionality for control and protection and are summarized for example by Forghani-zadeh, H. P. and G. A. Rincon-Mora (2002) in "Current-sensing techniques for DC-DC converters", 45th IEEE Midwest Symp. Circuits Systems.
Digital schemes exist, for example Ilic, M. and D. Maksimovic (2008) "Digital Average Current-Mode Controller for DC-DC Converters in Physical Vapor Deposition Applications." Power Electronics, IEEE Transactions on 23(3): 1428-1436; describes a system in which the design challenges relating to noise and sampling are evident. The challenges related to accurately and reliably sample current information in DC-DC conversion have led to predictive methods that obviate the need for accurate current sampling, for example : Kelly, A. and K. Rinne (2004), "Sensorless current-mode control of a digital dead-beat DC-DC converter", Applied Power Electronics Conference and Exposition, 2004. APEC '04.
Digital schemes sample the current sense signal for processing by an analog-to-digital converter (ADC). Discrete time preprocessing of the signal is also possible e.g. with a switched capacitor analog front end (AFE). The clocks involved in operation of a digital IC are typically synchronous to one another and derived from a master clock. Therefore the sampling of the current sense signal is correlated to the switching frequency. This makes the current signal particularly prone to noise and crosstalk from signals related to the master clock. The PWM switching frequency is a particular problem.
Therefore, there is a need to devise a current sense scheme that is not prone to correlated noise relative to the device master clock frequency.

BRIEF SUMMARY OF THE INVENTION

The present invention relates to a switched power converter comprising means for providing a master clock and a power stage for generating an output voltage according to a switching signal and an input voltage by means of a switching element. The power stage comprises means for sensing a current and an analog to digital converter for digitizing a sensed current. The power stage further comprises means for deriving a local clock from the master clock to control a sampling of the analog to digital converter.
The clock for clocking a compensator controlled by control law that generates a pulse width modulation (PWM) switching signal by means of PWM modulator may be derived from the master clock.
As the local clock clocks the sampling ADC to sample the sensed current, the sampling of the sensed current is de-correlated from the other signals of the power converter that are generated by means clocked by the master clock such as the switching signal of the power stage. De-correlated sampling of a sensed current provides superior accuracy, resolution and quality compared to prior-art methods.
The power stage further may further comprise a modulo-counter for deriving a local clock from the master clock for clocking a sampling ADC for sampling a sensed current. The sampling being performed by the local clock generated by the modulo-counter has the effect of de-correlating the sampling frequency of the ADC from the switching frequency of the switching signal. This happens because the frequency of the local clock generated by the modulo-counter is slightly offset from an integer division of the master clock.
For this purpose, the modulo-counter comprises a modulo-n-counter with modulus n that increments every time the master clock pulses to produce a mod-n-count. The modulo-counter may further comprise a modulo-m-counter with modulus m that increments by an increment every time the local clock pulses to produce a mod-m-count. A pulse of the local clock is triggered when mod-n-count and mod-m-count are equal. The moduli m and n are chosen such that modulus m is not an integer multiple of modulus n. Furthermore, the increment is chosen such that it is an integer division of modulus n, but not an integer division of modulus m. The effect of choosing m and n such that m is not an integer multiple of n is that a periodic shift by one clock cycle of the master clock occurs when triggering a next sequence of local clock cycles.
The present invention further relates to a system comprising a plurality of switched power converters as described above and means for providing a master clock. Each power stage further comprising a modulo-counter with a sequence length for deriving a local clock from the master clock for controlling the analog to digital converter, wherein each modulo-counter is configured such that its sequence length differs from another modulo-counter.
As each converter's clocks run at a slightly different frequency, noise immunity across the system between converters is improved.
The present invention further relates to a method for controlling a power stage of a switched digital power converter. The method comprises: sensing a current for obtaining a sensed current; deriving a local clock from a master clock such that the local clock and the master clock are de-correlated as defined above; digitizing the sensed current with an analog to digital converter being controlled by the local clock for obtaining a digitized sensed current; and
using the digitized sensed current for controlling the power converter.

BRIEF DESCRIPTION OF THE DRAWINGS

Reference will be made to the accompanying drawings, wherein:

Fig. 1     shows a current sense arrangement of a power converter;

Fig. 2     shows a block diagram of a sinc filter for averaging a digitized sensed current;

Fig. 3     shows a diagram showing an averaged sensed current IsenAv, a filtered averaged sensed current IsenFilt; a digitized sensed current IsenQ; a sensed current IsenOut; and an output voltage Vout of a power stage;

Fig. 4     shows details of Fig. 3;

Fig. 5     shows a diagram of a sensed current Isen (top); an averaged sensed current IsenAv (middle)and a digitized sensed current IsenQ for correlated sampling;

Fig. 6     shows a diagram of a sensed current Isen (top); an averaged sensed current IsenAv (middle)and a digitized sensed current IsenQ for de-correlated sampling;

Fig. 7     shows block diagram of decimating cascaded integrator comb (CIC) filter;

Fig. 8     shows an implementation of a decimating CIC filter;

Fig. 9     shows an integrate and reset implementation of a decimating CIC filter;

Fig. 10    shows an arrangement of the modulo-counter; and

Fig. 11    shows the signals associated with operation of the modulo-counter of figure 10.

DETAILED DESCRIPTION OF THE INVENTION

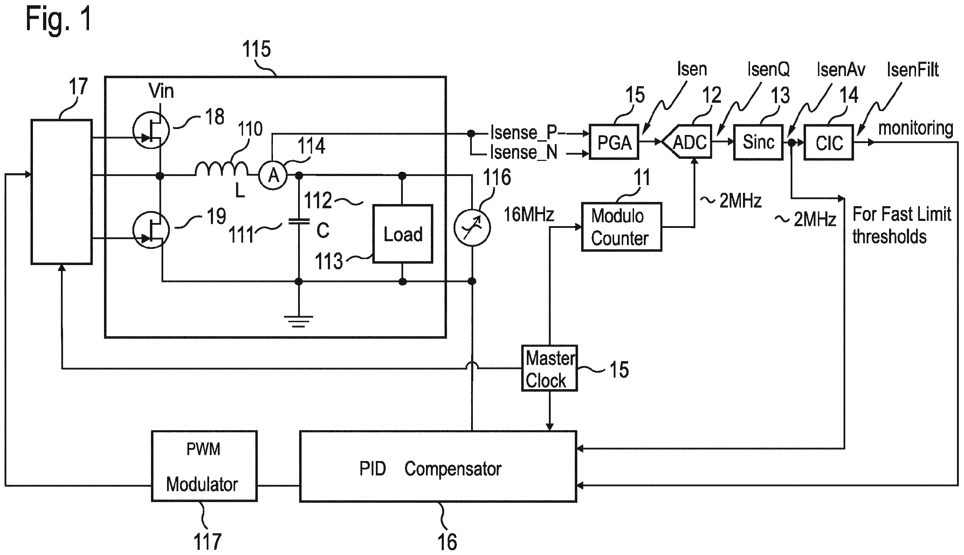

Figure 1 shows a switched power converter comprising a switchable power stage 115 and a current sense arrangement of a power stage of a switched power converter. The power converter comprises a controller 16 generating a control signal that drives a driver 17. The driver generates a switching signal for switching the switchable power stage 115. The power stage comprises a dual switching element comprising a high-side switch 18 and a low-side switch 19, an inductor 110 and a capacitor 111 for supplying power to a load 26. The power stage comprises means 114 for measuring the inductor current supplied and means 116 for measuring the output voltage.

The sensed current, in this example being a differential current Isense_P and Isense_N, is amplified by a programmable gain amplifier PGA 5. The ADC 2 samples the amplified current Isen for obtaining a digitized sensed current IsenQ which is further processed by filtering. The filtering comprises a sinc-filter 3 for obtaining an averaged sensed current IsenAv which is further filtered by a decimating CIC filter for obtaining a filtered averaged sensed current IsenFilt. The filtered averaged sensed current IsenFilt is used for monitoring the current.

The switched power converter comprises means for providing a master clock, for example a master clock generator 15 or just an interface for forwarding a clocking signal from an external master clock generator. Generally, all clocks are derived from the master clock, for example the clock for clocking a compensator 16 controlled by control law that generates a pulse width modulation (PWM) switching signal by means of PWM modulator 117.

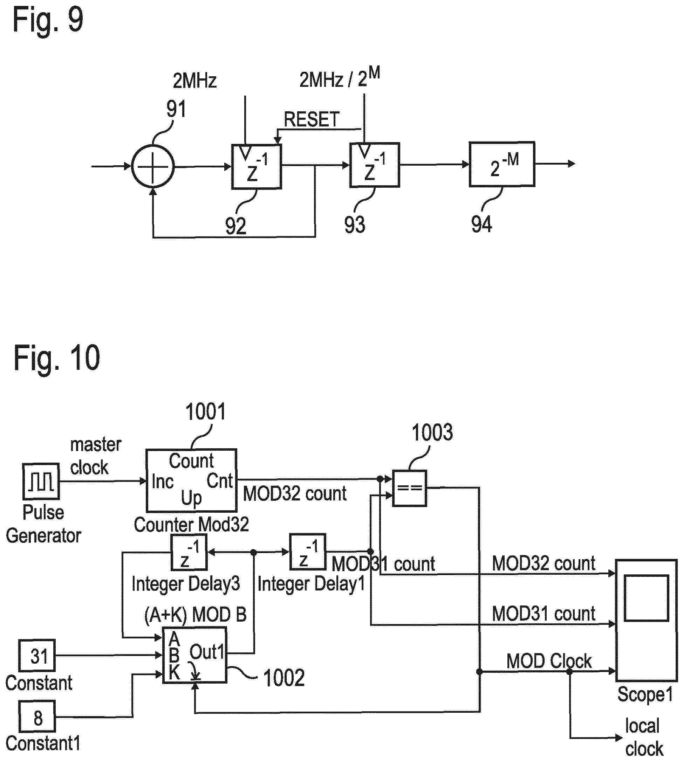

The power stage further comprises a modulo-counter 1 for deriving a local clock from the master clock for clocking the ACD 2. The sampling being performed by the local clock generated by the modulo-counter has the effect of de-correlating the sampling frequency of the ADC from the switching frequency of the switching signal. This happens because the frequency of the local clock generated by the modulo-counter is slightly offset from an integer division of the master clock. For this purpose, the modulo-counter comprises a modulo-n-counter with modulus n that increments every time the master clock pulses, see counter Mod32 1001 with modulus n=32 in Fig. 10 and produces a mod-n-count. The modulo-counter further comprises a modulo-m-counter with modulus m, see counter Mod31 1002, that increments by an increment every time the local clock pulses and produces a mod-m-count. A pulse of the local clock is triggered when mod-n-count and mod-m-count are equal, see relational operator block 1003 in Fig. 10. The moduli m and n are chosen such that modulus m is not an integer multiple of modulus n. Furthermore, the increment is chosen such that it is an integer division of modulus n, but not an integer division of modulus m.

For example, assuming a switching frequency of 500kHz and a master clock frequency of 16MHz, incrementing the modulo counter by increment=8 with a modulus of m=31 - i.e. count=mod(count, 31), yields the following sequence from the modulo-m-counter: {0,8,16,24,1,9....}; i.e. a pulse of the local clock is issued from the modulo counter on master clock counts 0,8, 16 etc. Therefore, the local clock generated by the modulo-counter is approximately 2MHz but is de-correlated from the 16MHz clock because its pattern only repeats over 24 sequences. A first sequence is {0, 8, 16, 24}. A second sequence is {1, 9, 17, 25}. After 24 sequences the first sequence will re-appear.

The effect of choosing m and n such that m is not an integer multiple of n in this example is that a pulse or a clock cycle of the local clock is not triggered on master clock count 32 but on master clock count 33. Therefore, a periodic shift by one clock cycle of the master clock occurs when triggering a next sequence of local clock cycles. Hence, in this example the local clock is not an integer division of 32 MHz but slightly offset, therefore, approximately 2 MHz.

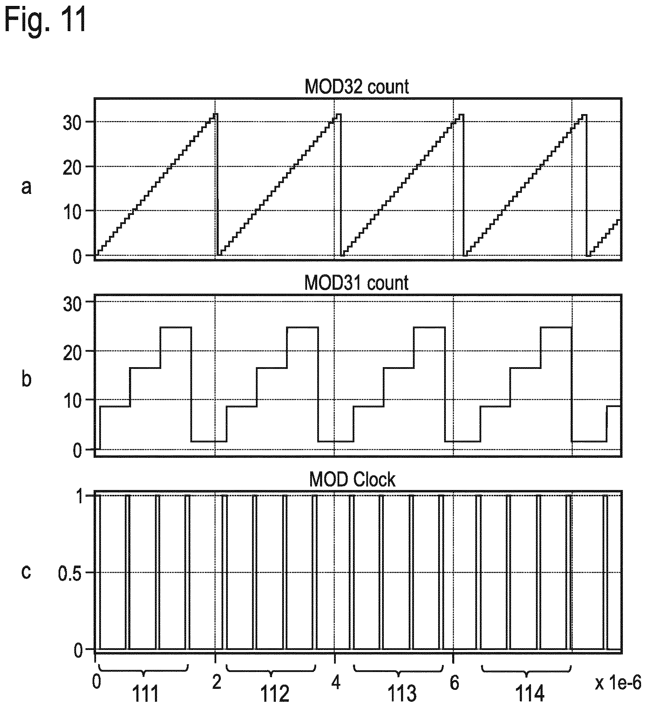

The signals associated with exemplary implementation of Figure 10 can be seen in Figure 11. Fig. 11 a shows the mod-32-count, Fig. 11b the mod-31-count and Fig. 11c the pulses of the local (MOD) clock. Referring to Fig. 11c, the local clock comprises a first sub-sequence 111, a second sub-sequence 112, a third sub-sequence 113 and a fourth sub-sequence 114, each sub-sequence consisting of four local clock pulses. The local clock pulses of the first sub-sequence 111 occur on master clock counts 0, 8, 16, 24. The local clock pulses of the second sub-sequence 112 occur on master clock counts of 33, 41, 49, 57 or taking into count the modulus of 32 on master clock counts of 1, 9, 17, 25. Hence, sub-sequence 112 is delayed by on master clock pulse to sub-sequence 111 as its pulses do not occur on master clock counts of 32, 40, 48 and 52. The pulses of the third sub-sequence occur on master clock counts of 66, 74, 82, 90. Hence, sub-sequence 113 is delayed by one master clock pulse to sub-sequence 112 and two master clock pulses to sub-sequence 111. Sub-sequence 114 is delayed by one master clock pulse to sub-sequence 113, two master clock pulses to sub-sequence 112 and three master clock pulses to sub-sequence 111.

A pulse of the local (MOD) clock is triggered, when mod-32-count and mod-31-count are equal. The values of the mod-31-count correspond to the sub-sequences. For example, the first sub-sequence 111 consisting of pulses of the local clock occurring on master clock counts 0, 8, 16, 24 are equal to the values of the mod-31-count 0, 8, 16, 24. The second sub-sequence 112 consisting of pulses of the local clock occurring on master clock counts 33, 41, 49, 57 or taking into account the modulus of 32 on master clock counts 1, 9, 17, 25 are equal to the values of the mod 31-count 1, 9, 17, 25. The modulo-m-counter provides the benefit of de-correlated current sampling but also provides additional system benefits. Noise insensitivity may be improved when the modulo-m-counter is used to clock the voltage ADC that would be used to regulate the voltage loop used in such a DC-DC conversion system.

Furthermore, electromagnetic interference (EMI) benefits would exist in a system whereby the modulo-m counter is used to clock the PWM of the DC-DC converter with the current sense being clocked from the master clock. Moreover, several modulo counters may be employed, each being used to generate de-correlated clocks in an IC so as to minimise crosstalk between the clocks.

In a system consisting of several DC-DC converters the modulo-m-counters in each DC-DC converter could be configured differently so that they run on different sequence lengths, making each converter's clocks run at a slightly different frequency, improving noise immunity across the system between converters.

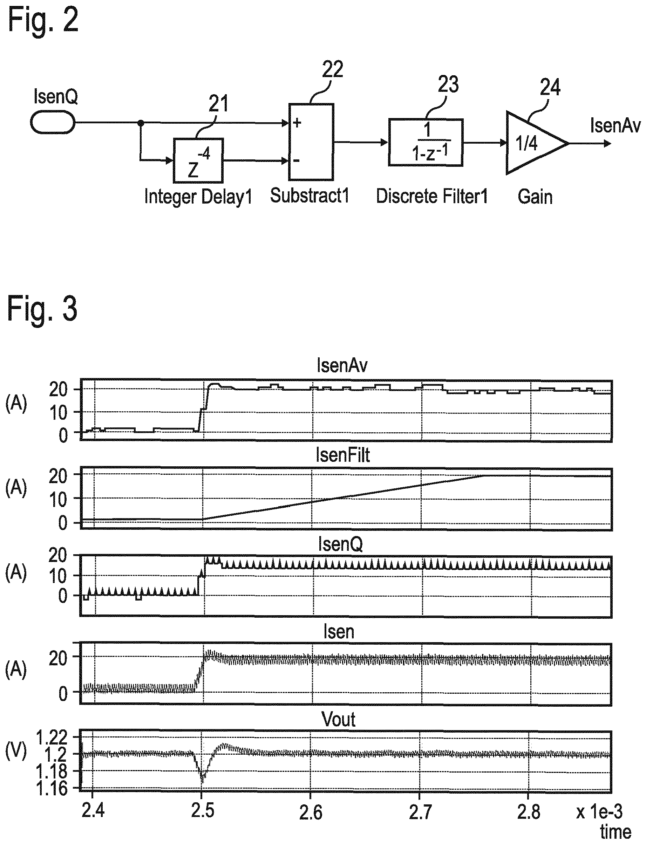

Fig. 2 shows an implementation shows an implementation of a fast averaging filter. The fast averaging filter, producing IsenAv, is a non-decimating sinc-filter with a transfer function of:

$$\frac{1}{4} \frac{\left(1 - z^{-4}\right)}{\left(1 - z^{-1}\right)}$$

The sinc-filter comprises an integer delay stage 21, a subtract stage 22, a discrete filter 23 and a gain stage 24.

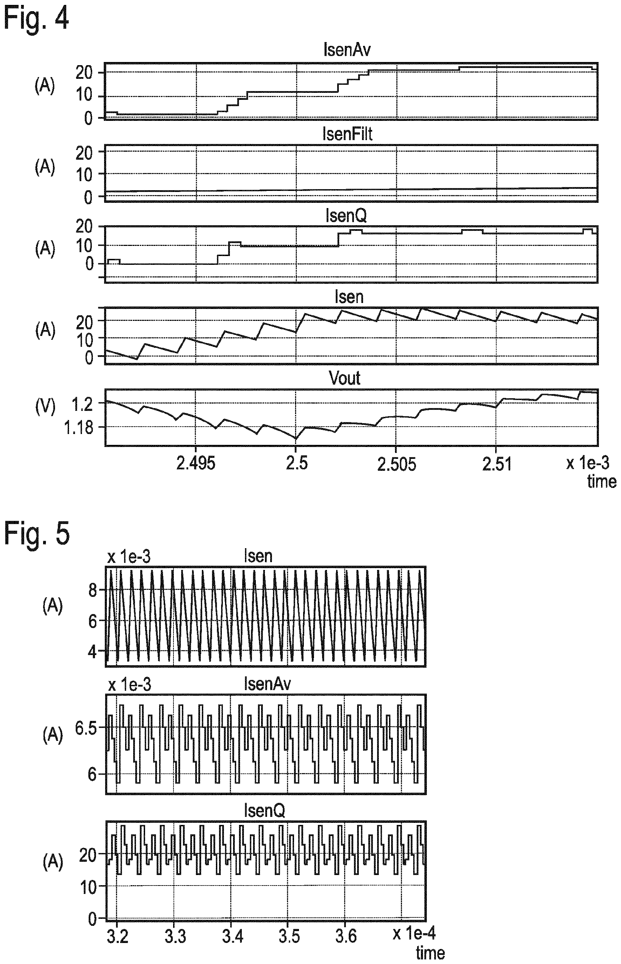

The simulations of Fig. 3 and Fig. 4 show the operation of this arrangement in response to a 1A to 20A step load change.

The output of the current sense arrangement is shown in the simulations of Fig. 4 as IsenAv and reacts with a group delay of 2 samples ($1\mu$s). It is therefore fast enough and provides an adequate level of filtering for average current limiting and (fast) mode change detection. It is evident that IsenQ contains significant quantisation noise from the ADC, but that this can be removed by filtering as evident in the IsenAv and IsenFilt signals. This is achieved by the decorrelation effect of the rational sampling process as disclosed above, which causes the current signal to be sampled over several cycles of an inductor current (24 in the previous example). In steady state conditions, this rational sampling allows more information to enter the filter over the repetition period of the sequence compared to correlated sampling which would deliver the same sampling points each switching period. From a signal processing perspective it can be said that the quantization noise of the ADC is being spread out across the spectrum by the rational, decorrelated sampling, yielding a lower noise floor as a result, and therefore, filtering can improve the SNR of the resulting signal.

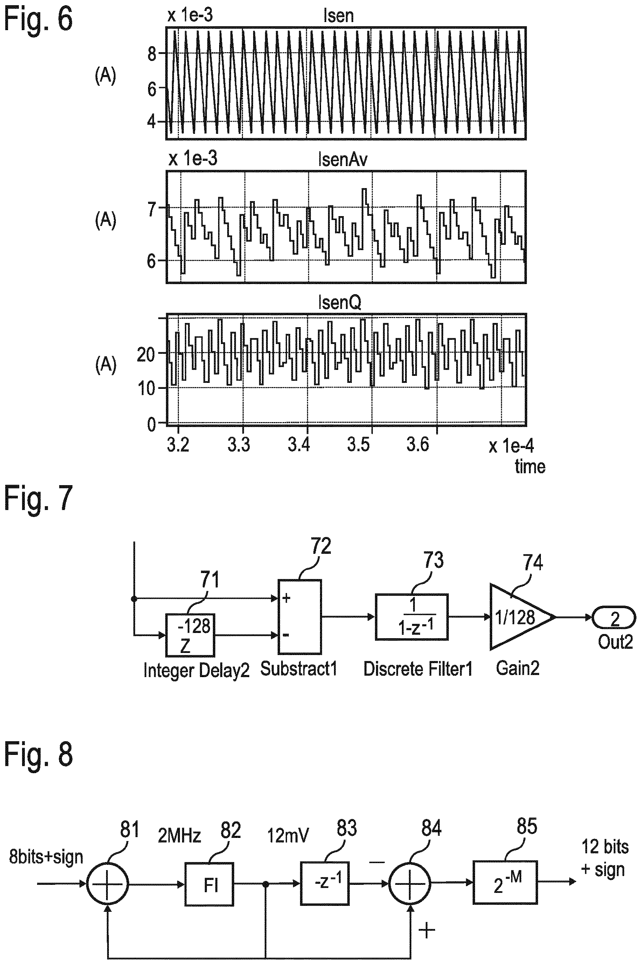

Fig. 5 shows that the prior-art correlated sampling method results in repetitive signals on IsenQ and IsenAV such that filtering does not improve the resolution of the filtered result. In contrast, the de-correlated sampling of Fig. 6 shows that there is no visually discernible correlation, with the signals appearing more noise like. Accordingly, filtering can improve the resolution of the result. This is borne out in experiments and simulation, with the decorrelated sampling yielding an average current value of 6.361A versus 6.393A actual (99.94% or 10.6 bits) and the pior-art correlated sampling yielding an average current value of 6.393A versus 6.397A actual (99.5% or 7.6 bits).

Current monitoring requires a higher degree of filtering which is achieved with a filter with a larger number of taps to achieve a very high resolution. As mentioned, the resolution achievable by filtering will be limited without the de-correlated sampling method. The functional diagram of Fig. 7 shows a SINC filter with 128 taps, for example. The filter comprises a delay stage 71 with 128 taps, a subtract stage 72, a discrete filter 73 and a gain stage 74.

As a decimating filter this is achieved as a CIC (Hogenauer) implementation as shown in Fig. 8. The CIC comprises a Cascaded Integrator Comb whereby an integrator comprised of blocks 81,82 is clocked at the higher input rate (2MHz) and the differentiator output stage (comb stage) comprised of blocks 83,84 is clocked at the lower output rate (2MHz/M), implementing the transfer function :

$$\frac{1}{2^M} \frac{\left(1 - z^{-M}\right)}{\left(1 - z^{-1}\right)}$$

The division by $2^M$ is implemented in block 85.
The differentiator does not need to be implemented explicitly and can be incorporated into the integration / decimation step by way of an integrate and reset approach as shown in Fig. 9, where blocks 91,92 implements the integrator, block 93 is the resettable output register performing the function of the differentiator and block 94 performs the scaling.
The output of this block is shown in the simulation of Figure 3 as IsenFilt (note that the signal is shown undecimated at the 2MHz rate). No quantisation noise is visible on the processed signal.
The current sense scheme described herein is capable of a high resolution which is further improved by filtering.

**Claims**

1. Switched power converter comprising:

   means for providing a master clock (15);
   a power stage (115) for generating an output voltage according to a switching signal and an input voltage by means of a switching element (18,19), the power stage (115) comprising means for sensing a current and an analog to digital converter (12) for digitizing a sensed current; the power stage (115) further comprising means (11) for deriving a local clock from the master clock to control a sampling of the analog to digital converter (12), wherein the means for deriving the local clock form the master clock comprise a modulo-counter comprising

      a modulo-n-counter (1001) with modulus n that increments every time the master clock pulses for producing a mod-n-count
   a modulo-m-counter (1002) with modulus m that increments by an increment every time the local clock pulses for producing a mod-m-count;
   means (1003) for triggering a pulse of the local clock when mod-n-count and mod-m-count are equal,
   wherein m and n are chosen such that m is not an integer multiple of n and the increment is chosen such that it is an integer division of n, but not an integer division of m.

2. The switched power converter according to claim 1, wherein m and n are chosen such that m is an integer multiple of n, minus one.

3. The switched power converter according to claim 1 or 2, wherein the switching signal is a pulse width modulation signal generated by a compensator (16) controlled by control law, wherein the control law processes the sensed current.

4. The switched power converter according to claim 1, wherein the power stage comprises a sinc-filter (13) for averaging a digitized sensed current and a cascaded integrator comb decimating filter (14) for filtering an averaged digitized sensed current.

5. System comprising a plurality of switched power converters and means for providing a master clock; each power stage of the plurality of power converters further comprising a modulo-counter with a sequence length for deriving a local clock from the master clock for controlling the analog to digital converter according to claim 1, wherein each modulo-counter is configured such that its sequence length differs from another modulo-counter.

6. Method for controlling a power stage of a switched digital power converter, the method comprising:

   sensing a current for obtaining a sensed current;
   deriving a local clock from a master clock;
   digitizing the sensed current with an analog to digital converter being controlled by the local clock for obtaining a digitized sensed current; and
   using the digitized sensed current for controlling the power converter;
   wherein deriving a local clock from a master clock comprises:

      generating a periodic sequence of pulses of the local clock having a sequence length, wherein the periodic sequence comprises a plurality of sub-sequences, wherein each sub-sequence of the plurality of sub-sequences comprises an equal number of pulses of the local clock and wherein each sub-sequence is delayed to a following sub-sequence by a delay and wherein each sub-sequence is triggered on a master clock pulse; and further comprising

counting pulses the master clock for obtaining master clock counts;

applying a modulo operation with modulus n to the master clock counts for obtaining mod-n-counts;

counting pulses of the local clock with an increment for obtaining incremented local clock counts;

applying a modulo operation with modulus m to the incremented local clock for obtaining a mod-m-counts;

triggering a pulse of the local clock when mod-n-counts and mod-m-counts are equal; wherein m and n are chosen such that m is not an integer multiple of n and the increment is chosen such that it is an integer division of n, but not an integer division of m.

7. The method according to claim 6 comprising:
filtering the digitized sensed current with a sinc-filter for obtaining an averaged sensed current.

8. The method according to claim 7 comprising:

filtering the averaged sensed current with a decimating cascaded integrator comb filter for obtaining a filtered averaged sensed current and using the filtered averaged sensed current for monitoring the current.

9. The method according to claim 10 further comprising:
digitizing an output voltage of the power stage with an analog-to-digital converter being clocked by the local clock.

10. The method according to claim 6, further comprising:
deriving another local clock from a master clock using the other local clock for clocking another clocked means of the switched power converter.

## Patentansprüche

1. Geschalteter Stromrichter, umfassend:

Mittel zum Bereitstellen eines Master-Takts (15);
eine Leistungsstufe (115) zum Erzeugen einer Ausgangsspannung gemäß einem Schaltsignal und einer Eingangsspannung mittels eines Schaltelements (18, 19), wobei die Leistungsstufe (115) Mittel zum Erfassen eines Stroms und einen Analog-Digital-Umsetzer (12) zum Digitalisieren eines erfassten Stroms umfasst; und die Leistungsstufe (115) ferner Mittel (11) zum Ableiten eines lokalen Takts aus dem Master-Takt zur Steuerung einer Abtastung des Analog-Digital-Umsetzers (12) umfasst, wobei die Mittel zum Ableiten des lokalen Takts aus dem Master-Takt einen modulo-Zähler umfassen, der Folgendes umfasst:

einen modulo-n-Zähler (1001) mit Modul n, der jedes Mal inkrementiert, wenn der Master-Takt pulst, um einen mod-n-Zählwert zu produzieren;
einen modulo-m-Zähler (1002) mit Modul m, der jedes Mal inkrementiert, wenn der lokale Takt pulst, um einen mod-m-Zählwert zu produzieren;
Mittel (1003) zum Triggern eines Impulses des lokalen Takts, wenn der mod-n-Zählwert und der mod-m-Zählwert gleich sind, wobei m und n so gewählt werden, dass m kein ganzzahliges Vielfaches von n ist, und das Inkrement so gewählt wird, dass es eine ganzzahlige Teilung von n ist, aber keine ganzzahlige Teilung von m.

2. Geschalteter Stromrichter nach Anspruch 1, wobei m und n so gewählt werden, dass m ein ganzzahliges Vielfaches von n, minus eins, ist.

3. Geschalteter Stromrichter nach Anspruch 1 oder 2, wobei das Schaltsignal ein Impulsbreitenmodulationssignal ist, das durch einen Kompensator (16) erzeugt wird, der durch ein Regelungsgesetz gesteuert wird, wobei das Regelungsgesetz den erfassten Strom verarbeitet.

4. Geschalteter Stromrichter nach Anspruch 1, wobei die Leistungsstufe ein Sinc-Filter (13) zum Mitteln eines digitalisierten erfassten Stroms und ein kaskadiertes Integrierer-Kamm-Dezimierungsfilter (14) zum Filtern eines gemittelten digitalisierten erfassten Stroms umfasst.

5. System, das mehrere geschaltete Stromrichter und Mittel zum Bereitstellen eines Master-Takts umfasst; wobei jede Leistungsstufe der mehreren Stromrichter ferner einen modulo-Zähler mit einer Sequenzlänge zum Ableiten eines lokalen Takts aus dem Master-Takt zur Steuerung des Analog-Digital-Umsetzers nach Anspruch 1 umfasst, wobei jeder modulo-Zähler so ausgelegt ist, dass sich seine Sequenzlänge von einem anderen modulo-Zähler unterscheidet.

6. Verfahren zum Steuern einer Leistungsstufe eines geschalteten digitalen Stromrichters, wobei das Verfahren Folgendes umfasst:

Erfassen eines Stroms zum Erhalten eines erfassten Stroms;
Ableiten eines lokalen Takts aus einem Master-Takt;
Digitalisieren des erfassten Stroms mit einem Analog-Digital-Umsetzer, der durch den lokalen Takt gesteuert wird, um einen digitalisierten erfassten Strom zu erhalten; und
Verwenden des digitalisierten erfassten Stroms zum Steuern des Stromrichters;
wobei Ableiten eines lokalen Takts aus einem Master-Takt Folgendes umfasst:

Erzeugen einer periodischen Sequenz von Impulsen des lokalen Takts mit einer Sequenzlänge, wobei die periodische Sequenz mehrere Teilsequenzen umfasst, wobei jede Teilsequenz der mehreren Teilsequenzen eine gleiche Anzahl von Impulsen des lokalen Takts umfasst und wobei jede Teilsequenz um eine Verzögerung gegenüber einer folgenden Sequenz verzögert ist und wobei jede Teilsequenz an einem Master-Taktimpuls getriggert wird; und ferner Folgendes umfasst:

Zählen von Impulsen des Master-Takts, um Master-Takt-Zählwerte zu erhalten;
Anwenden einer modulo-Operation mit Modul n auf die Master-Takt-Zählwerte, um mod-n-Zählwerte zu erhalten;
Zählen von Impulsen des lokalen Takts mit einem Inkrement, um inkrementierte lokale Taktzählwerte zu erhalten;
Anwenden einer modulo-Operation mit Modul m auf den inkrementierten lokalen Takt, um mod-m-Zählwerte zu erhalten;
Triggern eines Impulses des lokalen Takts, wenn mod-n-Zählwerte und mod-m-Zählwerte gleich sind;
wobei m und n so gewählt werden, dass m kein ganzzahliges Vielfaches von n ist, und das Inkrement so gewählt wird, dass es eine ganzzahlige Teilung von n ist, aber keine ganzzahlige Teilung von m.

7. Verfahren nach Anspruch 6, umfassend:
Filtern des digitalisierten erfassten Stroms mit einem Sinc-Filter, um einen gemittelten erfassten Strom zu erhalten.

8. Verfahren nach Anspruch 7, umfassend:

Filtern des gemittelten erfassten Stroms mit einem dezimierenden kaskadierten Integrierer-Kamm-Filter, um einen gefilterten gemittelten erfassten Strom zu erhalten, und
Verwenden des gefilterten gemittelten erfassten Stroms zum Überwachen des Stroms.

9. Verfahren nach Anspruch 10, ferner umfassend:
Digitalisieren einer Ausgangsspannung der Leistungsstufe mit einem Analog-Digital-Umsetzer, der durch den lokalen Takt getaktet wird.

10. Verfahren nach Anspruch 6, ferner umfassend:
Ableiten eines anderen lokalen Takts aus einem Master-Takt unter Verwendung des anderen lokalen Takts zum Takten anderer getakteter Mittel des geschalteten Stromrichters.

**Revendications**

1. Convertisseur de puissance commuté comprenant :

des moyens pour fournir une horloge maîtresse (15) ;
un étage de puissance (115) pour générer une tension de sortie en fonction d'un signal de commutation et une tension d'entrée au moyen d'un élément de commutation (18, 19), l'étage de puissance (115) comprenant des moyens pour détecter un courant et un convertisseur analogique-numérique (12) pour numériser un courant détecté ; l'étage de puissance (115) comprenant en outre des moyens (11) pour dériver une horloge locale à partir de l'horloge maîtresse pour commander un échantillonnage du convertisseur analogique-numérique (12), dans lequel les moyens pour dériver l'horloge locale à partir de l'horloge maîtresse comprennent un compteur modulo comprenant
un compteur modulo-n (1001) ayant un modulus n qui augmente chaque fois que l'horloge maîtresse génère des impulsions pour produire un compte modulo-n,
un compteur modulo-m (1002) ayant un modulus m qui augmente d'un incrément chaque fois que l'horloge maîtresse génère des impulsions pour produire un compte modulo-m,
des moyens (1003) pour déclencher une impulsion de l'horloge locale lorsqu'un compte modulo-n et un compte modulo-m sont égaux,
dans lequel m et n sont choisis de telle sorte que m ne soit pas un multiple entier de n et l'incrément est choisi de telle sorte qu'il soit une division entière de n mais ne soit pas une division entière de m.

**2.** Convertisseur de puissance commuté selon la revendication 1,
dans lequel m et n sont choisis de telle sorte que m soit un multiple entier de n moins un.

**3.** Convertisseur de puissance commuté selon la revendication 1 ou 2,
dans lequel le signal de commutation est un signal de modulation d'impulsions en durée généré par un compensateur (16) commandé par une loi de commande, dans lequel la loi de commande traite le courant détecté.

**4.** Convertisseur de puissance commuté selon la revendication 1,
dans lequel l'étage de puissance comprend un filtre sinc (13) pour moyenner un courant détecté numérisé et un filtre de décimation en peigne à intégrateur en cascade (14) pour filtrer un courant détecté numérisé moyenné.

**5.** Système comprenant une pluralité de convertisseurs de puissance commutés et des moyens pour fournir une horloge maîtresse ; chaque étage de puissance de la pluralité de convertisseurs de puissance comprenant en outre un compteur modulo ayant une longueur de séquence pour dériver une horloge locale à partir de l'horloge maîtresse pour commander le convertisseur analogique-numérique selon la revendication 1, dans lequel chaque compteur modulo est configuré de telle sorte que sa longueur de séquence soit différente de celle d'un autre compteur modulo.

**6.** Procédé pour commander un étage de puissance d'un convertisseur de puissance numérique commuté, le procédé consistant :

à détecter un courant pour obtenir un courant détecté ;
à dériver une horloge locale à partir d'une horloge maîtresse ;
à numériser le courant détecté avec un convertisseur analogique-numérique qui est commandé par l'horloge locale pour obtenir un courant détecté numérisé ; et
à utiliser le courant détecté numérisé pour commander le convertisseur de puissance ;
dans lequel le fait de dériver une horloge locale à partir d'une horloge maîtresse consiste :

à générer une séquence périodique d'impulsions de l'horloge locale ayant une longueur de séquence, dans lequel la séquence périodique comprend une pluralité de sous-séquences, dans lequel chaque sous-séquence de la pluralité de sous-séquences comprend un nombre égal d'impulsions de l'horloge locale et dans lequel chaque sous-séquence est retardée à une sous-séquence suivante par un délai et dans lequel chaque sous-séquence est déclenchée sur une impulsion d'horloge maîtresse, et consistant en outre :

à compter des impulsions de l'horloge maîtresse pour obtenir des comptes d'horloge maîtresse ;
à appliquer une opération modulo avec un modulus n aux comptes d'horloge maîtresse pour obtenir des comptes modulo-n ;
à compter des impulsions de l'horloge locale avec un incrément pour obtenir des comptes d'horloge locale incrémentés ;
à appliquer une opération modulo avec un modulus m à l'horloge locale incrémentée pour obtenir des comptes modulo-m ;
à déclencher une impulsion de l'horloge locale lorsque des comptes modulo-n et des comptes modulo-m sont égaux ; dans lequel m et n sont choisis de telle sorte que m ne soit pas un multiple entier de n et l'incrément est choisi de telle sorte qu'il soit une division entière de n mais ne soit pas une division entière de m.

**7.** Procédé selon la revendication 6, consistant :
à filtrer le courant détecté numérisé avec un filtre sinc pour obtenir un courant détecté moyenné.

**8.** Procédé selon la revendication 7, consistant :

à filtrer le courant détecté moyenné avec un filtre de décimation en peigne à intégrateur en cascade (14) pour obtenir un courant détecté moyenné filtré et
à utiliser le courant détecté moyenné filtré pour surveiller le courant.

**9.** Procédé selon la revendication 10, consistant en outre :
à numériser une tension de sortie de l'étage de puissance avec un convertisseur analogique-numérique qui est cadencé par l'horloge locale.

**10.** Procédé selon la revendication 6, consistant en outre :

à dériver une autre horloge locale à partir d'une horloge maîtresse ;
à utiliser l'autre horloge locale pour cadencer d'autres moyens cadencés du convertisseur de puissance commuté.

## Fig. 1

EP 3 008 476 B1

# Fig. 2

# Fig. 3

# Fig. 4

# Fig. 5

Fig. 6

Fig. 7

Fig. 8

# Fig. 9

# Fig. 10

## Fig. 11

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **FORGHANI-ZADEH, H. P. ; G. A. RINCON-MORA.** Current-sensing techniques for DC-DC converters. *45th IEEE Midwest Symp. Circuits Systems,* 2002
- **ILIC, M. ; D. MAKSIMOVIC.** Digital Average Current-Mode Controller for DC-DC Converters in Physical Vapor Deposition Applications. *Power Electronics, IEEE Transactions,* 2008, vol. 23 (3), 1428-1436

- **KELLY, A. ; K. RINNE.** Sensorless current-mode control of a digital dead-beat DC-DC converter. *Applied Power Electronics Conference and Exposition,* 2004